# NEUE EUROPÄISCHE PATENTSCHRIFT

(11) **EP 0 404 790 B2**
(45) Veröffentlichungstag und Bekanntmachung des Hinweises auf die Entscheidung über den Einspruch: **17.10.2007**
(45) Hinweis auf die Patenterteilung: 09.08.1995
(21) Anmeldenummer: 89903100.9
(22) Anmeldetag: 10.03.1989
(51) Int. Cl.: H01L 39/12

(54) **HOCHTEMPERATUR-SUPRALEITER**
HIGH-TEMPERATURE SUPERCONDUCTOR
SUPRACONDUCTEUR A HAUTE TEMPERATURE

(30) Priorität: 14.03.1988 DE 3808447
(43) Veröffentlichungstag der Anmeldung: 02.01.1991
(73) Patentinhaber: SIEMENS AKTIENGESELLSCHAFT, 80333 München (DE)
(72) Erfinder: EIBL, Oliver, D-8000 München 80 (DE)
(74) Vertreter: Patentanwälte Westphal, Mussgnug & Partner
(86) Internationale Anmeldenummer: PCT/DE1989/000154
(87) Internationale Veröffentlichungsnummer: WO 1989/008929

(56) Entgegenhaltungen:
- EP-A- 0 327 044
- EP-A- 0 330 214
- EP-A- 0 331 292
- EP-A- 0 332 291
- EP-A- 0 359 827
- EP-B- 0 332 291
- WO-A-89/07087
- US-A- 3 932 315
- Proceedings of the International Conference on High Temperature Superconductors and Materials and Mechanisms of Superconductivity, Interlaken, 28 February-04 March 1988, Part I, North-Holland (Amsterdam, NL); Physica C Superconductivity, vol. 153-155, part I, June 1988, Elsevier Science Publishers B.V., R.J. CAVA et al.: "Studies of oxygen-deficient Ba2YCu3O7-delta and superconductivity Bi(Pb)-Sr-Ca-Cu-O", pp. 560-565
- Physical Review Letters, vol. 60, no. 10, 07 March 1988, The American Physical Society (New York, US) C.W.CHU et al.:"Superconductivity up to 114 K in the Bi-Al-Ca-Sr-Cu-O compound system without rare-earth elements", pp. 941-943
- Proceedings of the International Conference on High Temperature Superconductors and Materials and Mechanisms of Superconductivity, Interlaken, 29. Februar - 4 März 1988, Part I, North-Holland (Amsterdam, NL); Physica C Superconductivity, vol. 153-155, Part I, Juni 1988, Elsevier Science Publishers B.V.; U. Braun et al.: "Constitution and synthesis of high Tc-superconductors"; pp. 499, 500
- Proceedings of the International Conference on High Temperature Superconductors and Materials and Mechanisms of Superconductivity, Interlaken, 29. Februar - 4. März 1988, Part I, North-Holland (Amsterdam, NL); Physica C Superconductivity, vol. 153-155, Part I, Juni 1988, Elsevier Science Publishers B.V.; C.W.CHU et al.: "New materials and high temperature superconductivity"; pp. 1138-1143
- Nikkei Chodendo (Nikkei Superconductors) March 7, 1988, pp. 1-4 einschliesslich einer englischen Übersetzung
- Superconductor Week vol. 2., no. 8, February 22, 1988, pp. 1-5
- Phys. Rev. B38, 1988 pp. 893ff, S.A. SUNSHINE et al: "Structure and physical properties of single crystals of the 84K superconductor Bi2.2Sr2Ca0.8Cu208+8
- Solid State Communications vol. 17, 1975, pp. 27-28; A.W. SLEIGHT et al.; "High-temperature superconductivity in the BaPb1-xBix03 system"
- Japanese Journal of Applied Physics, vol. 19, no. 5; 1980, pp. L231-L234; M. SUZUKI et al.: "Preparation of Superconducting BaPb1-xBix03 thin films by RF sputtering"
- Riedel de Haën: Laborchemikalien 1992
- Metaleurop, PPM Pure Metals GmbH; Analysenzertifikat zu Kupferoxid (26/01/93)
- TH. GOLDSCHMIDT AG, Data sheet to Bismuth trioxide
- Proceedings of the International Conference on High Temperature Superconductors and Materials and Mechanisms of Superconductivity, Interlaken, 29. Februar - 4. März 1988, Part I, North-Holland (Amsterdam, NL); Physica C Superconductivity, vol. 153-155, Part I, Juni 1988, Elsevier Science Publishers B.V.; H. MAEDA et al.; "New high-Tc superconductor without rare earth element"; pp. 602-607.
- Japanese Journal of Applied Physics vol. 28, no. 1, January 1989, pp. L57-L59, H. NOBUMASA et al.: "Observation of the high-Tc phase and determination of the Pb position in a Bi-Pb-Sr-Ca-Cu oxide superconductor
- Japanese Journal of Applied Physics vol. 27, no. 6, June 1988, pp. L1041-L1043; M. TAKANO et al.: "High-Tc phase promoted and stabilized in the Bi, Pb-Sr-Ca-Cu-0 System"
- Japanese Journal of Applied Physics vol. 27, no. 6. June 1988, pp. L996-L998; Y. YAMADA et al.: "Pb introduction to the high-Tc superconductor Bi-Sr-Ca-Cu-0"
- Japanese Journal of Applied Physics vol. 27, no. 7, July 1988, pp. L1225-L1227; M. MIZUNO et al.: "Superconductivity of Bi2Sr2Ca2Cu3Pbx0y (x=0.2, x=0.4, x=0.6)"
- Japanese Journal of Applied Physics vol. 27, no. 8, August 1988, pp. L1476-L1479, U. ENDO et al.: "Preparation of the high-Tc phase of Bi-Sr-Ca-Cu-0 superconductor"
- Japanese Journal of Applied Physics vol. 27, no. 8, July 1988, pp. L1460-L1462, E. YANAGISAWA et al.: "Properties of Pb-doped Bi-SrCa-Cu-0 superconductors"
- Nature 332, 14.04.1988, 620-623
- Superconductivity News, 1, No. 8, 18.02-1988
- Departement of Condensed Matter Physics, Université de Genève, Research Report, 2004, Seiten 10-11

## Beschreibung

Die vorliegende Erfindung bezieht sich auf einen Hochtemperatur-Supraleiter.

Durch Bednorz und Müller sind Supraleiter des Systems Lanthan-Stronitum-Kupferoxid bekannt, die eine zuvor niemals erreichte hohe Sprungtemperatur des Übergangs von der Normalleitung in die Supraleitung haben. Für Yttrium-Barium-Kupferoxid erreichte Sprungtemperaturen liegen bei 70 bis 90 K. Ein anderes System, nämlich Wismut-Strontium-Kalzium-Kupferoxid ist kürzlich bekannt geworden, an dem bereits eingehende Untersuchungen durchgeführt worden sind. Untersucht worden ist der Einfluß der Sinter-Parameter, wie der Sintertemperatur, der Sinterdauer und des Sauerstoff-Partialdrucks beim Sinterprozeß.

Die Herstellung des oben an zweiter Stelle genannten Materials geht aus von den puverisierten Ausgangsstoffen, die gemischt, gemahlen und kaltgepreßt werden. Das Sintern erfolgt in Mikroprozessor-gesteuerten Öfen, wobei das Material auf ZirkonoxidPlatten aufliegt. Angewendete Sintertemperaturen bei Sinterung in Luft liegen bei 800, 860, 880, 900°C, wobei das Sintern zehn Stunden lang ausgeführt wurde.

Zur Messung der elektrischen Eigenschaften werden Gold-Kontake an den Proben angebracht. Die magnetischen Eigenschaften eines jeweiligen Materials werden durch Messung der Induktivität einer die Materialprobe umgebenden Spule bestimmt

In der älteren nachveröffentlichten europäischen Patentanmeldung EP-A 0 330 214 ist eine Zusammensetzung für ein supraleitendes Material mit Sprungtemperaturen über 100K beschrieben, welches der Summenformel (Bi Pb)₂ Sr₂ Ca₂ Cu₃ O_{y} besitzt.

Aus einem Konferenzbeitrag, nachveröffentlicht in Physica C. Superconductivity, vol. 153 -155, Part I, Juni 1988, Elsevier Science Publishers B. M.; R. J. CAVA et al.: "Studies of oxygen-deficient Ba₂YCO₇₋₆ and Superconductivity Bi(Pb)-Sr-Ca-Cu-O" sind supraleitende Materialien mit Sprungtemperaturen zwischen 90 und 100 Kelvin bekannt, denen die Zusammensetzung Bi₂Sr₂ Ca Cu₂ O₈ zugeschrieben wird.

Aufgabe der vorliegenden Erfindung ist es, die chemische Zusammensetzung von Hochtemperatur-Supraleitermaterial anzugeben, das hohe Sprungtemperatur größer als 90 K für die Supraleitung hat.

Diese Aufgabe ist mit mehrphasiges Material gemäß Anspruch 1 gelöst.

Der Erfindung liegt folgendes zugrunde:
An Proben des Systems BiSrCaCu₂Oₓ, diese Formel gibt die nominale Zusammensetzung an, wurde ein scharfer Abfall des Widerstandes und der Induktivität gemessen. Es wurde die Abhängigkeit des Null-Widerstands von der Temperatur zwischen 55 und 175 K gemessen. Die Kurve der Abhängigkeit Null-Widerstand/Temperatur zeigte für Material, das in Luft bei Temperaturen von 860 bis 880° C zehn Stunden lang gesintert worden war, zwei Stufen des Widerstandsabfalls. Entsprechende lineare Extrapolation ergab Werte zwischen 100 und 105 K für einen supraleitenden Phasenübergang.

Dieses Ergebnis war ohne weiteres reproduzierbar festzustellen und für Proben mit längerer Sinterzeit auch sehr ausgeprägt Für Proben mit Sintertemperaturen von 900° C und darüber wurde halbleitendes Verhalten beobachtet.

Die weiteren im Rahmen der vorliegenden Erfindung durchgeführten Untersuchungen waren darauf gerichtet, aus dem untersuchten Material mit zwei- oder mehrphasigem Aufbau ein solches zu entwickeln, dessen struktureller Aufbau zu einer Sprungtemperatur von 100 bis 105 K führte.

Der Erfindung liegt die weitere Überlegung zugrunde, daß das oben angegebene Material mehrphasig ist und hier eine Koexistenz zweier Supraleiter-Materialien vorliegt, von denen das eine Material die angegeben hohe Sprungtemperatur besitzt.

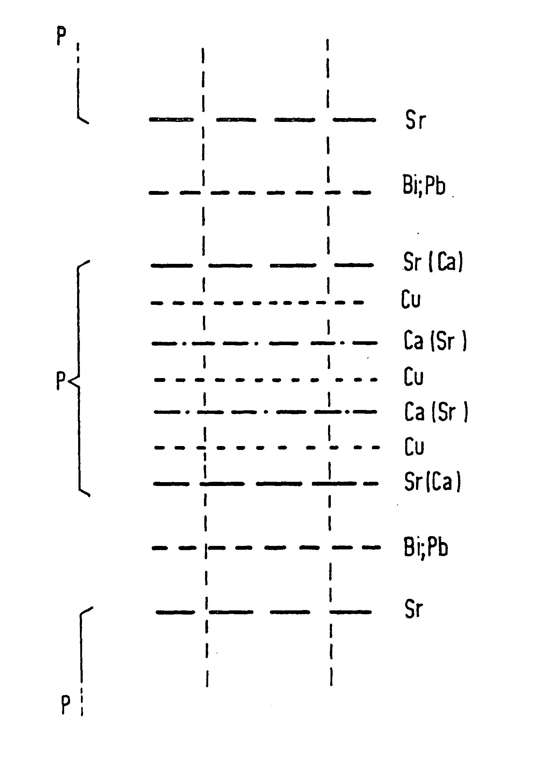

Dem Erfinder ist es gelungen herauszufinden, daß ein solches Material mit einer Sprungtemperatur von ungefähr 105 K dasjenige ist, das wenigstens weit überwiegend aus nur noch einer Phase des Systems Wismut-Strontium-Kalzium-Kupfer-Oxid, insbesondere mit teilweiser Wismut-Substitution durch Blei, besteht. Es ist aus Science, Band 239 (Febr. 1988), Seite 1015/1016, insbesondere Fig. 3, bekannt, daß das supraleitende Material des Systems mit einer Nominalzusammensetzung Wismutoxid-Strontium-Kalzium-Kupferoxid eine Schichtstruktur hat mit abwechselnd Wismutoxid-Schichten einerselts und Folgen von Schichten aus Struntium-/Kupfer-/ Kalzium (Strontium)-/Kupfer-/Strontiumoxid andererseits.

Im Rahmen der Untersuchungen, die zu der vorliegenden Erfindung geführt haben, wurde festgestellt, daß eine Phase mit den Gitterkonstanten a = 0,54 nm und c = 3 nm (gemessen aus elektronenmlkroskopischen Beugungsbildern), nämlich eine Phase wie sie aus der obengenannten Druckschrift bekannt ist, eine Sprungtemperatur von 80 K hat. Es wurde aber auch das Vorhandensein einer noch weiteren Phase festgestellt, für die die Gitterkonstante a wieder 0,54 nm beträgt. Jedoch für die die Gitterkonstante c = 3,8 nm, noch genauer ermittelt 3,7 bis 3,8 nm, festgestellt wurde. Noch weitergehende Untersuchungen führten zu der Erkenntnis, daß diese Phase außerdem technisch besonders vorteilhafte supraleitende Eigenschaften mit hoher Sprungtemperatur bei 105 K hat.

Das Material hat orthorhombisches Gitter mit einer nach bisherigen Analysen A-zentrierten orthorhombischen Symmetrie. Das elektronenmikrokopische Beugungsmuster in der /010/-Achse läßt zwischen A-zentriertem und F-zentriertem orthorhombischen Gitter unterscheiden.

Es wurde festgestellt, daß die Struktur mit a = 0,54 nm und c = 3,6 nm bis 3,8 nm eine 5- bzw. 8,7-fache Überstruktur parallel der /010/ bzw. /100/-Richtung hat. Die Einheitszelle dieses erfindungsgemäßen Materials weist eine Struktur auf, die BiOₓ-Doppelschichten und Perovskitzellen, aus Strontium-, (Kalzium-) und Kupferoxid bestehend, hat. Diese Einheitszellen können auch noch Wismut und/oder Blei enthalten, d.h. Blei kann neben Wismut enthalten sein. Die Struktur des erfindungsgemäßen Materials hat somit einen Sandwich-artigen Aufbau mit abwechselnd Schichten aus Wismutoxid bzw. (Bi₁₋ᵤ Pbᵤ)-Oxid und aus Perovskitzellen, die wiederum in sich schichtenartig aufgebaut sind. Eine solche erfindungsgemäße Struktur ist die, die folgende Schichtenfolge mit z.B-auch u = 0 hat:
(Wismut₁₋ᵤ Bleiᵤ)/Strontium(Kalzium)/Kupfer/Kalzium(Strontium) /Kupfer/ Kalzium(Strontium)/Kupfer/Strontium (Kalzium)/(Wismut₁₋ᵤ Bleiᵤ) mit der schon oben angegebenen Gitterkonstanten c = 3,6 nm. Die in Klammern gesetzten Element können die zuvorgenannten Elemente zu einem Teil ersetzen.

Ein erfindungsgemäßes mehrphasiges Supraleitermaterial ist in Anspruch 1 offenbart.
Es kann d insbesondere ungefähr gleich 2 y oder ungefähr gleich u sein und u kann zwischen 0,1 und 0,3 liegen, z.B. kann u gleich 0,2 ± 10 % sein. Wie festgestellt, kann die Sprungtemperatur solchen
Materials Werte gleich oder höher 105 K und bis 120 K haben.

Selbst wenn Material nicht ganz die angegebenen hohen Sprungtemperaturen von 105 bis 110 K aufweist, ist dieses Material dennoch von großem technischen Vorteil gegenüber konkurrierenden Supraleitermaterialien einschlägiger Art, nämlich weil das Material außerdem nicht so schnell mit der Atmosphäre reagiert, d.h. hohe Resistenz gegen die Atmosphäre besitzt.

Die Herstellung erfindungsgemäßen Materials erfolgt in an sich üblicher Weise. Es werden die jeweiligen Ausgangssubstanzen (Oxide, Karbonate und dgl.) entsprechend der obigen Zusammensetzung mit wahlweise vorgegebenen, Im Rahmen der obigen Grenzen liegenden Werten für x, y, d und u eingewogen. Je nach auftretenden Verlusten während der einzelnen nachfolgenden Herstellungsschritte (Verlust beim Mahlen, Filtrieren, Umsetzen und Sintern) werden entsprechende Zuschläge bei der Einwaage berücksichtigt, damit sich das Ausgangsmaterial ergibt.

Die eingewogenen Substanzen werden miteinander gemischt und gemahlen, wobei das Mischen insbesondere während des Mahlens erfolgt und das Mahlen mit üblichen Kugelmühlen durchgeführt wird. Das nach dem Mahlen vorliegende Gut wird in üblicherweise zur Durchführung des Umsatzes (Uberführung in die Oxide) bei üblich hoher Temperatur (700° bis 1000°, insbesondere 800° bis 820° C) umgesetzt Nach wiederum durchzuführendem Mahlen erfolgt das Pressen und Sintern der Proben. Gesintert wird zwischen 800° und 1000° C, vorzugsweise bei 880° ± 20° C, insbesondere 860° bis 865° C, zehn Stunden, insbesondere jedoch 60 bis 120 Stunden lang und vorzugsweise an Luft. Dieses Herstellungsverfahren ergibt bereits supraleitendes Material, nämlich Körper mit den durch die Formgabe und das Pressen vorgegebenen Abmessungen. Weitere, für derartiges Material übliche Bearbeitungsgänge können durchgeführt werden.

Ein Beispiel ist folgendes
nominelle Einwaage: Bi_{1,7}Pb_{0,4}Sr_{1,7}Ca_{2,1}Cu₃
als Bi₂O₃, PbO, SrCO₃, CaO und CuO.
Der Umsatz erfolgt bei 800°C drei Stunden und bei 820° C 10 bis 20 Stunden lang an Luft mit einer Zwischenmahlung. Dann wird wieder gemahlen und verpreßt. Die Sinterung findet bei 860 bis 865°C 60 bis 120 Stunden an Luft statt.
Eine stattdessen ausgeführte Sinterung bei 843°C, 60 bis 120 Stunden in einem Argon-Sauerstoffgemisch bei P(O₂)=1/13 bar führt zu einem gleich guten Ergebnis.

Die beigefügte Figur zeigt einen Ausschnitt einer Schichtenfolge der Struktur eines erfindungsgemäßen Materials. Die c-Achse verläuft in vertikaler Richtung.

Mit P sind drei Perovskitzellen bezeichnet.

## Patentansprüche

1. Mehrphasiges supraleitendes Material mit einer Sprungtemperatur von 105K bis 110K des Systems Bi Sr (Ca) Cu Oₓ
mit einer weit überwiegenden Phase mit der nominalen Zusammensetzung
(Bi₁₋ᵤ Pbᵤ) ₂ (Sr_{1-x-y} Caₓ Bi_{y}) ₄ Cu ₃O_{10+d} (d = delta) mit
0,01 < x
0 < y < x <0,5
0 < d ≈ 2y
0 < u.
welches eine orthorombische Perovskitüberstruktur aufweist, die in der Einheitszelle eine Schichtstruktur entlang ihrer Gitterkonstanten c von 3,6 nm mit ersten und zweiten alternierenden Schichten aufweist,
wobei die erste alternierende Schicht eine Doppelschicht aus Wismutoxid und /oder Wismut/Bleioxid ist und
die zweite alternierende Schicht von schichtenartig aufgebauten Perovskit-Zellen aus Strontium(Kalzium)-Oxid und Kupferoxid gebildet wird,
so dass die Schichtstruktur eine Schichtenfolge von [Wismut(Blei)/ Strontium(Kalzium)/ Kupfer/ Kalzium(Strontium)/Kupfer/ Kalzium(Strontium)/ Kupfer/ Strontium(Kalzium)/ Wismut(Blei)]-Oxid hat, wobei das in Klammern genannte Element, das jeweils voranstehende zu einem Anteil ersetzen kann.

## Claims

1. Multi-phase superconducting material having a transition temperature of 105K to 110K of the system BiSr(Ca)CuOₓ
with a by far predominant phase having the nominal composition
(Bi₁₋ᵤPbᵤ)₂(Sr_{1-x-y}CaₓBi_{y})₄Cu₃O_{10+d} (d = delta), where
0.01 < x
0<y<x<0.5
0<d≈2y
0<u,
having an orthorhombic perovskite superlattice provided in the unit cell with a layer structure along its lattice constant c of 3.6 nm with first and second alternating layers,
wherein the first alternating layer is a double layer of bismuth oxide and/or bismuth/lead oxide and
the second alternating layer is formed by perovskite cells of strontium (calcium) oxide and copper oxide having a layer-like construction,
so that the layer structure has a layer sequence of [bismuth (lead)/strontium (calcium)/copper/calcium (strontium)/copper/calcium (strontium)/copper/strontium (calcium)/bismuth (lead)] oxide, wherein the element mentioned in brackets can partly replace the preceding element.

## Revendications

1. Matériau supraconducteur à plusieurs phases, ayant une température de changement brusque de la conductivité de 105 K à 110 K, du système BiSr (Ca) Cu Oₓ ayant une phase très prépondérante de composition nominale
(Bi₁₋ᵤ Pbᵤ)₂ (Sr₁₋ₓ Caₓ Bi_{y})₄ Cu₃ O_{10±d} (d = delta)
avec 0,01 < x
0 < y inférieur ou égal à x < 0,5
0 inférieur ou égal à d
0 inférieur ou égal à u
qui a une superstructure de perovskite qui a, dans la maille élémentaire, une structure en couche le long de sa constante c de réseau de 3,6 nm ayant des première et seconde couches alternées, et
dans lequel la première couche alternée est une couche double d'oxyde de bismuth et/ou d'oxyde de bismuth et/ou de plomb, et
la seconde couche alternée est formée par des mailles de perovskite constituées sous la forme de couches et formées par de l'oxyde de strontium (calcium) et de l'oxyde de cuivre,
de sorte que la structure en couches possède une succession de couches d'oxyde de [bismuth (plomb)/strontium (calcium)/cuivre/calcium (strontium)/cuivre/calcium (strontium)/cuivre/strontium (calcium)/bismuth (plomb)], l'élément indiqué entre crochets pouvant remplacer pour une certaine proportion l'élément indiqué respectivement précédemment.
